(19) Europäisches Patentamt
European Patent Office
Office européen des brevets

(11) **EP 3 602 198 B1**

(12) **EUROPÄISCHE PATENTSCHRIFT**

(45) Veröffentlichungstag und Bekanntmachung des Hinweises auf die Patenterteilung:
**04.10.2023   Patentblatt 2023/40**

(21) Anmeldenummer: **18712138.9**

(22) Anmeldetag: **14.03.2018**

(51) Internationale Patentklassifikation (IPC):
***G03F 7/20*** *(2006.01)*      ***G03F 7/00*** *(2006.01)*

(52) Gemeinsame Patentklassifikation (CPC):
**G03F 7/7065; G03F 7/7085**

(86) Internationale Anmeldenummer:
**PCT/EP2018/056352**

(87) Internationale Veröffentlichungsnummer:
**WO 2018/177747 (04.10.2018 Gazette 2018/40)**

(54) **VERFAHREN ZUM DETEKTIEREN VON PARTIKELN AN DER OBERFLÄCHE EINES OBJEKTS, WAFER UND MASKENBLANK**

METHOD FOR DETECTING PARTICLES ON THE SURFACE OF AN OBJECT, WAFER AND MASK BLANK

PROCÉDÉ DE DÉTECTION DE PARTICULES À LA SURFACE D'UN OBJET, D'UNE PLAQUE ET D'UNE ÉBAUCHE DE MASQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **28.03.2017   DE 102017205212**

(43) Veröffentlichungstag der Anmeldung:
**05.02.2020   Patentblatt 2020/06**

(73) Patentinhaber: **Carl Zeiss SMT GmbH**
**73447 Oberkochen (DE)**

(72) Erfinder:
• **BEYER, Oliver**
**89520 Heidenheim (DE)**
• **GERHARD, Michael**
**73432 Aalen (DE)**

(74) Vertreter: **Kohler Schmid Möbus Patentanwälte Partnerschaftsgesellschaft mbB**
**Gropiusplatz 10**
**70563 Stuttgart (DE)**

(56) Entgegenhaltungen:
WO-A1-00/00817          CN-B- 102 117 850
DE-A1-102014 204 171          US-A- 4 767 660
US-A1- 2016 153 914          US-A1- 2017 045 823
US-B1- 6 608 321

**Beschreibung**

Hintergrund der Erfindung

Die Erfindung betrifft ein Verfahren zum Detektieren von abgelagerten Partikeln an der Oberfläche eines Objekts, umfassend: Bestrahlen eines Teilbereichs der Oberfläche des Objekts mit Messstrahlung, Detektieren von an dem bestrahlten Teilbereich gestreuter Messstrahlung, sowie Detektieren der Partikel an der Oberfläche des Objekts anhand der detektierten Messstrahlung.

Bei den abgelagerten Partikeln handelt es sich typischerweise um unerwünschte Störpartikel. Anhand der Anzahl der detektierten Störpartikel kann z.B. die Sauberkeit in einem Reinraum überprüft werden. Bei dem (Test-)Objekt kann es sich grundsätzlich um ein beliebiges Objekt handeln, das eine Oberfläche aufweist, die für das Detektieren von Störpartikeln geeignet ist.

Das oben beschriebene Verfahren kann beispielsweise zur Detektion von abgelagerten Partikeln an der Oberfläche eines plattenförmigen Objekts in Form eines (typischer Weise unbelichteten) Wafers oder eines Maskenblanks für die Mikrolithographie, beispielsweise für die EUV-Lithographie, durchgeführt werden. Das Messprinzip der Partikeldetektion beruht auf der Streuung der Messstrahlung an der Oberfläche des Objekts. Messvorrichtungen, die auf dem Prinzip der Partikeldetektion durch die Detektion von an einer Oberfläche rückgestreuter Messstrahlung beruhen, werden beispielsweise von der Firma Rudolph Technologies, Inc. unter dem Handelsnamen "Reflex FSI zur Untersuchung von Wafern oder unter dem Handelsnamen "Reflex TT MBI" zur Untersuchung von Masken angeboten.

Bei diesen Messvorrichtungen wird typischer Weise Messstrahlung in Form eines Laserstrahls unter einem vorgegebenen Einfallswinkel auf die Oberfläche des Objekts eingestrahlt. Die Detektion der an der Oberfläche gestreuten Messstrahlung erfolgt in einer Dunkelfeldmessung, d.h. der Detektionswinkelbereich, innerhalb dessen die an der Oberfläche des Objekts gestreute Messstrahlung detektiert wird, weicht vom Einfallswinkel der auf die Oberfläche eingestrahlten Messstrahlung ab, so dass der an der Oberfläche reflektierte Strahlungsanteil ignoriert wird.

Bei einer solchen Dunkelfeldmessung wird an einer perfekten, vollständig glatten Oberfläche der gesamte an der Oberfläche reflektierte Strahlungsanteil unterdrückt, so dass nur die an der Oberfläche gestreute Messstrahlung detektiert wird. Jede Oberfläche weist jedoch auf mikroskopischer Ebene eine Rauheit auf, so dass bei der Detektion der Messstrahlung unweigerlich auch ein Anteil von an der Oberfläche reflektierter Messstrahlung detektiert wird. Dieser Anteil der detektierten Messstrahlung erzeugt ein Untergrundsignal, dessen Stärke von der Rauheit bzw. von der Polierqualität der Oberfläche sowie ggf. von der Homogenität von auf die Oberfläche aufgebrachten (dünnen) Schichten abhängig ist, an deren Oberseite die zu untersuchende Oberfläche gebildet ist.

Zusätzlich zu dem Untergrundsignal, das auch als Haze-Signal bezeichnet wird, wird bei der Detektion der Messstrahlung auch ein Defekt-Signal aufgenommen. Typischer Weise wird bei dem oben beschriebenen Messprinzip die Oberfläche des Objekts in ein Messraster eingeteilt und ein jeweiliges Matrixelement bzw. ein Teilbereich der Oberfläche wird von der Messstrahlung abgescannt. Die während des Scannens des Teilbereichs bzw. des Matrixelements detektierte Messstrahlung wird aufsummiert bzw. integriert. Pro Teilbereich bzw. pro Matrixelement setzt sich die detektierte Messstrahlung bzw. das detektierte Messsignal additiv aus dem Untergrund- bzw. Haze-Signal und aus dem Defekt-Signal zusammen. Das Defekt-Signal wird durch auf der Oberfläche abgelagerte Partikel oder ggf. Mulden sowie durch lokale Defekte wie Kratzer oder lokale Flächendefekte hervorgerufen. Kratzer oder lokale Flächendefekte können in der Regel von Partikeln unterschieden werden, indem lokale Muster in der detektierten Messstrahlung von benachbarten Teilbereichen erkannt werden. Beispielsweise kann für den Fall, dass die detektierte Messstrahlung in mehreren benachbarten Teilbereichen über einem Schwellwert liegt, ein lokaler Flächendefekt erkannt werden. Während Flächendefekte typischer Weise eine zweidimensionale Ausdehnung aufweisen, weisen Kratzer typischer Weise eine gerichtete Ortsverteilung mit einer im Wesentlichen eindimensionalen Ausdehnung auf und können daher in der Regel ebenfalls erkannt und von Partikeln unterschieden werden. Unabhängig von der Unterscheidung zwischen Partikeln und Kratzern bzw. lokalen Flächendefekten im Defekt-Signal ist es für die Detektion von Partikeln erforderlich, eine Unterscheidung zwischen den Werten der Streulichtintensität, die dem Haze-Signal zugeordnet sind, von den Werten der Streulichtintensität, die dem Defekt-Signal zugeordnet werden, vorzunehmen. Das Haze-Signal bzw. die Rauheit der Oberfläche limitiert somit die Partikelnachweisgrenze, d.h. den minimalen Durchmesser, bei der Partikel noch eindeutig nachgewiesen werden können. Eine typische Größenordnung für die Nachweisgrenze von Partikeln bzw. für den minimalen Partikeldurchmesser liegt bei der vorliegenden Anwendung bei ca. 100 nm oder darunter.

In der US2016/0153914A1 sind ein Verfahren und eine Vorrichtung zum Inspizieren von Halbleiterproben beschrieben. Bei der Inspektionsvorrichtung werden unterschiedliche Wellenlängenbereiche für unterschiedliche zu untersuchende Schichten einer jeweiligen Halbleiterprobe in Abhängigkeit davon ausgewählt, ob sich in oder in der Nähe dieser Schichten ein Absorbermaterial befindet.

Aufgabe der Erfindung

Aufgabe der Erfindung ist es, ein Verfahren zum Detektieren von Partikeln an der Oberfläche eines Objekts anzugeben, bei dem die Nachweisgrenze der detektierten Partikel gesenkt werden kann.

Gegenstand der Erfindung

Diese Aufgabe wird gelöst durch ein Verfahren der eingangs genannten Art, bei dem die Oberfläche des Objekts während der Schritte des Bestrahlens und des Detektierens der Messstrahlung mit einer Antireflex-Beschichtung und/oder mit einer Oberflächenstruktur zur Reduzierung der Reflektivität für die Messstrahlung versehen ist.

Erfindungsgemäß wird vorgeschlagen, die Detektion der Partikel an einem Objekt vorzunehmen, dessen Oberfläche vor der Detektion der Partikel behandelt wurde, um die Reflektivität für die Messstrahlung zu reduzieren. Zu diesem Zweck kann auf die Oberfläche des Objekts eine Antireflex-Beschichtung aufgebracht sein und/oder an der Oberfläche kann eine Oberflächenstruktur angebracht sein, die typischerweise in einem der Partikeldetektion vorausgehenden Schritt an der Oberfläche angebracht werden. Neben Antireflex-Beschichtungen können auch Oberflächenstrukturen die Reflektivität der Oberfläche für die Messstrahlung deutlich reduzieren, weil keine scharfe Grenzfläche vorhanden ist, an der die Messstrahlung gemäß den Fresnelschen Formeln reflektiert werden kann. Sowohl eine (möglichst homogene) Antireflex-Beschichtung als auch die Oberflächenstruktur verursachen typischer Weise bei der vorliegenden Anwendung bzw. selbst nur einen vernachlässigbar kleinen Streulichtanteil bzw. diese verändern die Rauigkeit der Oberfläche im für die Streulichtmessung relevanten Ortsfrequenzbereich nur geringfügig.

Die Reduzierung der Reflektivität der Oberfläche durch die Antireflex-Beschichtung und/oder durch die Oberflächenstruktur ist für die Detektion der Partikel günstig, da hierdurch auch die Streuung und somit die Intensität des Untergrund- bzw. des Haze-Signals verringert wird, so dass weniger Messstrahlung an der rauen Oberfläche des Objekts gestreut wird. Das Defektsignal wird durch an der Oberfläche der Antireflex-Beschichtung und/oder der Oberflächenstruktur abgelagerte Partikel erzeugt, so dass die Streuung an den Partikeln nicht bzw. nur sehr geringfügig von der darunter liegenden Antireflex-Beschichtung und/oder der Oberflächenstruktur beeinflusst wird, insbesondere wenn es sich um nicht zu stark absorbierende Partikel handelt. Durch die Reduzierung der Reflektivität wird auch die Breite der Haze-Verteilung bzw. des Haze-Signals reduziert. Der Intensitätsschwellwert, oberhalb dessen das gemessene Signal bzw. die Messstrahlung als Defektsignal interpretiert wird, liegt typischerweise bei 3σ, wobei σ die Standardabweichung der Haze-Verteilung bezeichnet. Daher legt die 3σ-Breite (gemessen vom Maximum der Haze-Verteilung) die untere Partikelnachweisgrenze fest.

Unter der Annahme, dass die Antireflex-Beschichtung und/oder die Oberflächenstruktur die Reflektivität der Oberfläche für die Messstrahlung um die Hälfte verringert, reduziert sich die gesamte Haze-Verteilung um die Hälfte, d.h. es wird sowohl der Intensitätswert des Maximums der Haze-Verteilung als auch die Standardabweichung der Haze-Verteilung halbiert. Der Abstand zwischen dem Maximum der Haze-Verteilung und dem Maximum der Partikelverteilung bleibt demgegenüber konstant. Die Konstanz des Abstandes beruht auf der Annahme, dass sich die gesamte Streulichtintensität, die von einem Flächenelement bzw. einem Teilbereich der Oberfläche des Objekts ausgeht, additiv aus dem Streulichtanteil der Oberfläche (Haze) und dem Defekt-Streulichtanteil zusammensetzt. Das Signal-zu-Rausch-Verhältnis bei der Detektion der Partikel nimmt durch die Verringerung der Reflektivität daher zu und die Nachweisgrenze der Partikel wird gesenkt. Es versteht sich, dass die Antireflex-Beschichtung bzw. die Oberflächenstruktur sich typischer Weise über die gesamte Oberfläche erstrecken, an der Partikel detektiert werden sollen.

Bei dem bestrahlten Teilbereich der Oberfläche handelt es sich um einen typischer Weise annähernd punktförmigen Teilbereich, auf den die Messstrahlung typischer Weise unter einem vorgegebenen Einfallswinkel, in der Regel senkrecht zur Oberflächennormalen eingestrahlt wird. Häufig handelt es sich bei der Oberfläche, an der die Partikel detektiert werden, um eine plane Oberfläche, so dass die Flächennormale an allen Orten bzw. Teilbereichen der Oberfläche die gleiche Richtung aufweist. Um an der gesamten Oberfläche Partikel detektieren zu können, wird der Teilbereich bzw. das Matrixelement, über das die detektierte Messstrahlung aufintegriert wird, typischer Weise in einer scannenden Bewegung über die Oberfläche geführt, wozu sowohl das zu untersuchende Objekt als auch die Messstrahlung bzw. die Messlichtquelle relativ zueinander bewegt werden können.

Bei einer Variante werden die Partikel an der Oberfläche eines Objekts in Form eines Maskenblanks für die Mikrolithographie oder eines Wafers für die Mikrolithographie detektiert. Typischer Weise wird der Nachweis von Partikeln an der Oberfläche eines unbelichteten, ggf. mit einer strahlungsempfindlichen Schicht (Resist) versehenen Wafers oder an einer nicht strukturierten Maske, beispielsweise einer nicht strukturierten EUV-Maske, durchgeführt. Bei einer solchen Messung kann gleichzeitig die Oberflächenrauigkeit des Wafers bzw. der Maske vermessen werden. Geht es darum, Partikel an der Oberfläche eines Wafers oder einer Maske zu detektieren, ist es zur Reduzierung der Partikelnachweisgrenze günstig, wenn diese mit einer die Reflexion vermindernden Antireflex-Beschichtung und/oder mit einer geeigneten Oberflächenstruktur versehen sind. Die Anhaftung von Partikeln an einer derart behandelten Oberfläche unterscheidet sich ggf. nicht bzw. nur geringfügig von der Anhaftung an der Oberfläche eines herkömmlichen Wafers bzw. eines herkömmlichen Maskenblanks oder kann mittels einer geeigneten Kalibrierung in die an einem herkömmlichen Wafer bzw. einem herkömmlichen Maskenblank auftretende Partikelanzahl umgerechnet werden, so dass die Detektion von Partikeln an einem entsprechend modifizierten Wafer bzw. an einem entsprechend modifizierten Maskenblank dieselbe Aussagekraft hat wie die Detektion von Partikeln an einem nicht modifizierten Wafer bzw. an einem nicht modifizierten Maskenblank.

Bei einer weiteren Variante weist die Messstrahlung eine vorgegebene Mess-Wellenlänge auf. Die Messstrahlung ist typischer Weise monochromatisch, d.h. diese weist eine einzige, definierte Wellenlänge auf. Monochromatische Messstrahlung kann beispielsweise von einem Laser oder z.B. von einer Laserdiode erzeugt werden. In der Regel liegt die Mess-Wellenlänge der Messstrahlung im sichtbaren Wellenlängenbereich zwischen ca. 380 nm und ca. 750 nm, beispielsweise bei ca. 405 nm oder bei 635 nm. Die Verwendung von monochromatischer Messstrahlung hat sich für die Streulichtmessung als günstig erwiesen.

Bei einer weiteren Variante wird die gestreute Messstrahlung in einem Detektionswinkelbereich zwischen einem ersten Streuwinkel und einem zweiten Streuwinkel in Bezug auf die einfallende Messstrahlung detektiert. Die Detektion der an dem Teilbereich der Oberfläche gestreuten Messstrahlung nur in einem vorgegebenen Detektionswinkelbereich ist günstig, da die Oberflächenstreuung anisotrop ist (Bragg-Beugung), so dass der bzw. die Detektionswinkel mit der Ortsfrequenz des Haze-Signals korreliert ist/sind und durch eine geeignete Wahl des Detektionswinkelbereichs ein geeigneter Ortsfrequenzbereich für die Detektion ausgewählt werden kann, in dem das Haze-Signal bzw. die Oberflächenrauheit möglichst klein ist. Da die Streuung an Partikeln in einem bestimmten Durchmesserbereich im Wesentlichen als isotrop angenommen werden kann, kann der Detektionswinkelbereich so gewählt werden, dass das Verhältnis zwischen der Streulichtintensität der Partikel zur Streulichtintensität der Oberflächenstreuung möglichst groß ist. Um einen geeigneten Detektionswinkelbereich auszuwählen, sollte die Rauigkeit der Oberfläche des untersuchten Objekts möglichst genau bekannt sein und die Variation der Oberflächenrauigkeit sollte nicht zu groß sein.

Bei einer weiteren Variante ist die Antireflex-Beschichtung als Mehrlagen-Beschichtung ausgebildet. Eine Mehrlagen-Beschichtung weist typischer Weise eine Mehrzahl von Schichten mit alternierend hohem und niedrigem Brechungsindex auf, wobei die Schichtdicken und die Schichtmaterialien bzw. die Brechungsindizes der einzelnen Schichten so gewählt sind, dass die gewünschte Reduzierung der Reflektivität der Oberfläche des Objekts erreicht wird. Eine solche Mehrlagen-Beschichtung wird typischer Weise so ausgelegt, dass diese eine destruktive Interferenz für Messstrahlung bei der Mess-Wellenlänge erzeugt und auf diese Weise die Reflektivität reduziert. Gegebenenfalls kann die Mehrlagen-Beschichtung die Reflektivität der Oberfläche bzw. des Objekts über einen vergleichsweise großen Spektralbereich deutlich reduzieren. Es versteht sich, dass bei der Auslegung der Mehrlagen-Beschichtung typischer Weise auch das Material des Objekts, insbesondere der Brechungsindex des Objekts, berücksichtigt wird. An Stelle einer Mehrlagen-Beschichtung kann ggf. auch eine Antireflex-Beschichtung verwendet werden, die nur eine einzige Schicht aufweist. Eine Antireflex-Beschichtung kann insbesondere auch durch einen graduellen Übergang zwischen dem Brechungsindex der Umgebung und dem Brechungsindex des Materials des Objekts realisiert werden. Bei der Verwendung einer solchen Antireflex-Beschichtung mit mehreren Schichten nimmt der Brechungsindex von der Umgebung zum Material des Objekts graduell zu.

Bei einer weiteren Variante weist die Antireflex-Beschichtung in dem Detektionswinkelbereich zwischen dem ersten Streuwinkel und dem zweiten Streuwinkel eine winkelabhängige Reflektivität für die Messstrahlung auf, bei der eine Differenz zwischen einem maximalen Wert der Reflektivität und einem minimalen Wert der Reflektivität weniger als 5 %, bevorzugt weniger als 2 %, besonders bevorzugt weniger als 1 % beträgt. Die Reflektivität der Antireflex-Beschichtung sollte im Detektionswinkelbereich idealer Weise konstant sein, zumindest aber nur innerhalb des weiter oben angegebenen Bereichs schwanken.

Bei einer weiteren Variante liegt die Reflektivität der Antireflex-Beschichtung für die Messstrahlung in dem Detektionswinkelbereich zwischen dem ersten Streuwinkel und dem zweiten Streuwinkel bei weniger als 15 %, bevorzugt bei weniger als 5 %, insbesondere bei weniger als 1 %. Wie weiter oben beschrieben wurde, wird die Antireflex-Beschichtung für ein bestimmtes Material des Objekts optimiert. Die Reduzierung der Reflektivität bzw. die Reflektivität der Antireflex-Beschichtung ist daher vom Material des Objekts abhängig, an dem die Oberfläche gebildet ist und kann für unterschiedliche Materialien unterschiedlich groß sein. Idealer Weise ermöglicht es die Antireflex-Beschichtung, die Reflektivität der Oberfläche in dem Detektionswinkelbereich auf weniger als 1 % zu reduzieren.

Bei einer weiteren Variante ist die Oberflächenstruktur als nadelartige Mikrostruktur insbesondere in der Art einer Mottenaugenstruktur ausgebildet. Eine solche Mikrostruktur kann beispielsweise Nadeln bzw. nadelartige Strukturen mit einer lateralen Ausdehnung in der Größenordnung von weniger als ca. 1 $\mu$m und einer Länge in der Größenordnung von beispielsweise ca. 10 $\mu$m aufweisen. Durch eine solche Mikrostruktur kann ein im Wesentlichen stetiger Übergang des Brechungsindexes von der Umgebung zur Oberfläche des Objekts erzeugt werden, wodurch die Absorption der Messstrahlung erhöht wird und sich somit die Reflektivität der Oberfläche reduziert.

Bei einer weiteren Ausführungsform ist das Objekt aus Silizium gebildet. Unter der Formulierung, dass das Objekt aus Silizium gebildet ist, wird nicht zwingend verstanden, dass das Objekt vollständig aus Silizium besteht, vielmehr kann das Objekt ein Substrat aus Silizium aufweisen, an dem ggf. eine Beschichtung aufgebracht ist, beispielsweise mindestens eine Schicht aus epitaktisch aufgewachsenem Silizium oder aus einem anderen Material. Die Oberseite einer solchen Beschichtung kann die Oberfläche bilden, auf welche die Antireflex-Beschichtung aufgebracht und/oder an der die Oberflächenstruktur angebracht ist. Bei dem Objekt, das aus Silizium gebildet ist, kann es sich beispielsweise um einen Wafer für die Mikrolithographie handeln.

Die unbeschichtete Oberfläche eines Objekts aus Silizium weist typischer Weise eine hohe Reflektivität für Messstrahlung bei Mess-Wellenlängen im sichtbaren Wellenlängenbereich auf, die beispielsweise bei mehr als ca. 40 % liegen kann. Durch eine geeignete Antireflex-Beschichtung kann die Reflektivität von Silizium für Messwellenlängen im sichtbaren Wellenlängenbereich deutlich reduziert werden. Antireflex-Beschichtungen für Silizium sind beispielsweise aus der Diplomarbeit "Entspiegelung von Silizium-Photodioden nach dem Vorbild der Nanooptik von Mottenaugen". D. Gäbler, TU Illmenau, 2005, bekannt geworden. Neben Antireflex-Beschichtungen ohne eine Oberflächenstruktur werden dort auch strukturierte, beispielsweise hexagonale Oberflächenstrukturen in der Art von Mottenaugen beschrieben, die ggf. mit einer Antireflex-Beschichtung kombiniert werden können, um die Reflektivität von Silizium deutlich zu reduzieren. Als Antireflex-Beschichtung kann in diesem Fall beispielsweise eine - ggf. strukturierte - Schicht aus $Si_xN_y$, beispielsweise aus $Si_3N_4$, dienen.

Bei einer Weiterbildung ist die Oberflächenstruktur als schwarzes Silizium ausgebildet. Schwarzes Silizium stellt eine Oberflächenmodifikation von kristallinem Silizium dar und kann beispielsweise an der Oberfläche von Silizium durch hochenergetischen Beschuss mit Ionen oder mit ultrakurzen Laserpulsen erzeugt werden, wobei sich die weiter oben beschriebene nadelartige Mikrostruktur ausbildet, welche die Absorption der Messstrahlung erhöht und die Reflektivität reduziert.

Wie weiter oben beschrieben wurde, kann grundsätzlich die Reflektivität der Oberfläche reduziert werden, wenn ein gradueller oder ggf. kontinuierlicher Übergang des Brechungsindex von der Umgebung des Objekts, typischer Weise Luft, zum Material des Objekts erfolgt. Dies kann durch eine Antireflex-Beschichtung und/oder durch eine Oberflächenstruktur, beispielsweise durch eine Gitterstruktur oder eine Mottenaugenstruktur erreicht werden, die einen solchen Brechungsindexverlauf (als effektives Medium) erzeugt.

Bei einer weiteren Variante ist das Objekt aus einem optischen Filterglas zur Filterung der Messstrahlung bei der Mess-Wellenlänge, insbesondere aus einem Langpass-Filterglas, gebildet. Neben der Reflektivität der Oberfläche an der Vorderseite des Objekts, an der die Messstrahlung auf das Objekt eingestrahlt wird, spielt für die Streulichtmessung auch die Reflektivität an der Rückseite des Objekts eine Rolle, d.h. derjenigen Seite, die der Messstrahlung abgewandt ist, wenn das Objekt eine hohe Transmission für die Messstrahlung aufweist.

Auch die Reflexion von Messstrahlung an der Rückseite des Objekts sollte minimiert werden. Eine Möglichkeit zur Minimierung der Reflexion an der Rückseite des Objekts besteht darin, ein Objekt aus einem Material für die Messung zu verwenden, welches eine hohe Absorption bzw. einen hohen Absorptionskoeffizienten für die Messstrahlung aufweist. Bei dem Material des Objekts kann es sich beispielsweise um ein optisches Filterglas handeln, dessen Transmission bei der Mess-Wellenlänge sehr gering ist, so dass dieses beispielsweise im gesamten sichtbaren Wellenlängenbereich einen Reintransmissionsgrad von weniger als $10^{-5}$ bei einer Dicke von 3,0 mm aufweist, wie dies beispielsweise bei dem ionengefärbten Langpass-Filterglas RG1000 der Firma Schott der Fall ist. Das optische Filterglas kann beispielsweise an Stelle eines herkömmlichen, transparenten Glassubstrats verwendet werden, wie es ggf. bei Maskenblanks für die Mikrolithographie eingesetzt wird.

Bei einer weiteren Variante ist das Objekt aus einem Material gebildet, welches für die Messstrahlung einen Absorptionskoeffizienten von mehr als $1 \times 10^4$ 1/cm aufweist. Bei diesem Material kann es sich um das weiter oben erwähnte optische Filterglas handeln. Auch andere Materialien, beispielsweise Silizium, weisen für die Messstrahlung einen Absorptionskoeffizienten auf, der beispielsweise bei einer Mess-Wellenlänge von ca. 405 nm typischer Weise bei mehr als ca. $10^5$ 1/cm liegt.

Bei einer weiteren Variante weist das Objekt eine Dicke von mindestens 500 $\mu m$, bevorzugt von mindestens 1 mm auf. Die Absorption eines Materials nimmt mit zunehmender Dicke des Materials zu. Herkömmliche Silizium-Wafer weisen eine Dicke von ca. 650 $\mu m$ auf und absorbieren aufgrund des hohen Absorptionskoeffizienten (s.o.) nahezu die gesamte Messstrahlung, so dass praktisch keine Messstrahlung von der Rückseite eines herkömmlichen Wafers reflektiert wird.

Bei einer weiteren Variante wird in dem bestrahlten Teilbereich nur für den Fall ein Partikel detektiert, dass eine Streulichtintensität der an dem Teilbereich gestreuten Messstrahlung über einem Intensitätsschwellwert liegt. Für Streuzentren, deren Durchmesser $D_S$ bei weniger als ca. der halben Messwellenlänge, z.B. bei ca. 200 nm oder weniger liegt, gilt näherungsweise, dass die Streulichtintensität I proportional zur sechsten Potenz des Durchmessers ist, d.h. es gilt I - $D_S^6$ (Rayleigh-Streuung). Vergleichsweise große Streuzentren, wie sie durch Partikel hervorgerufen werden, führen daher zu einer hohen Streulichtintensität I, während die Rauheit bzw. Unebenheiten der Oberfläche eine geringere Streulichtintensität I hervorrufen. Wird in einem Teilbereich der Oberfläche eine Streulichtintensität I gemessen, die oberhalb des Intensitätsschwellwerts liegt, kann davon ausgegangen werden, dass in dem Teilbereich ein Partikel an der Oberfläche vorhanden ist, zumindest handelt es sich beim Überschreiten des Schwellwerts um eine notwendige Bedingung für das Vorhandensein eines Partikels in dem Teilbereich.

Bei einer weiteren Variante werden zumindest die Schritte des Bestrahlens des Objekts mit Messstrahlung und des Detektierens der gestreuten Messstrahlung an einer Messvorrichtung zur Vermessung von Wafern oder von Maskenblanks für die Mikrolithographie durchgeführt. Bei dem untersuchten Objekt kann es sich in diesem Fall um einen (modifizierten) Wafer bzw. um einen (modifizierten) Maskenblank handeln, es ist aber auch möglich, andere plattenförmige Objekte, die für die Messvorrichtung geeignete Abmessungen aufweisen, in einer solchen Messvorrichtung zu untersuchen. Der Schritt der Detektion von Partikeln kann ebenfalls an der Messvorrichtung vorgenommen werden, es ist aber auch möglich, die Auswertung der detektierten Messstrahlung in einer anderen, räumlich getrennten Vorrichtung vorzunehmen.

Bei einem Wafer kann an einer Oberfläche eine Antireflex-Beschichtung und/oder eine Oberflächenstruktur zur Reduzierung der Reflektivität der Oberfläche für Messstrahlung bei mindestens einer Mess-Wellenlänge im sichtbaren Wellenlängenbereich oder im UV-Wellenlängenbereich angebracht sein. Ein solcher Wafer (Mess-Wafer) kann vorteilhafter Weise bei der Durchführung des weiter oben beschriebenen Verfahrens verwendet werden. Die Antireflex-Beschichtung bzw. die Oberflächenstruktur kann auf die weiter oben im Zusammenhang mit dem Verfahren beschriebene Weise ausgebildet sein. Der Wafer besteht typischer Weise aus Silizium. Wie weiter oben beschrieben wurde, liegt der sichtbare Wellenlängenbereich zwischen 380 nm und 750 nm. Der UV-Wellenlängenbereich liegt im Sinne dieser Anmeldung bei Wellenlängen zwischen 190 nm und 380 nm. Die Verwendung von Messstrahlung bei kleineren Wellenlängen als im sichtbaren Wellenlängenbereich ist ggf. günstig, da die die Streulichtintensität an Partikeln (Rayleigh-Streuung) typischer Weise proportional zu $1/\lambda_M^4$ ist, wobei $\lambda_M$ die Messwellenlänge bezeichnet.

Bei einem Maskenblank für die Mikrolithographie, insbesondere für die EUV-Lithographie, kann an einer Oberfläche eine Antireflex-Beschichtung und/oder eine Oberflächenstruktur zur Reduzierung der Reflektivität der Oberfläche für Messstrahlung bei mindestens einer Mess-Wellenlänge im sichtbaren Wellenlängenbereich oder im UV-Wellenlängenbereich angebracht sein. Auch ein solcher Maskenblank, d.h. eine nicht strukturierte Maske, kann vorteilhaft bei dem weiter oben beschriebenen Verfahren verwendet werden, um die Partikelnachweisgrenze zu reduzieren.

Ein Maskenblank ist bei der Verwendung für die EUV-Lithographie typischer Weise aus einem so genannten Nullausdehnungs-Material gebildet, d.h. aus einem Material, welches einen geringen thermischen Ausdehnungskoeffizienten aufweist, wie beispielsweise die Glaskeramik Zerodur® (Marke von Schott) oder das titandotierte Quarzglas ULE® (Marke von Corning) oder andere Glaskeramiken bzw. titandotierte Quarzgläser, die einen kleinen thermischen Ausdehnungskoeffizienten aufweisen. Als Material von Maskenblanks für die VUV-Lithographie kann beispielsweise herkömmliches Quarzglas verwendet werden, das beispielsweise mit einer Chromschicht, z.B. aus NTAR7, versehen ist.

Die Antireflex-Beschichtung bei dem oben beschriebenen Wafer und/oder bei dem oben beschriebenen Maskenblank kann insbesondere wie weiter oben im Zusammenhang mit dem Verfahren beschrieben ausgebildet sein und in einem Detektionswinkelbereich zwischen dem ersten Streuwinkel und dem zweiten Streuwinkel eine winkelabhängige Reflektivität für die Messstrahlung aufweisen, bei der eine Differenz zwischen einem maximalen Wert der Reflektivität und einem minimalen Wert der Reflektivität weniger als 5 %, bevorzugt weniger als 2 %, insbesondere weniger als 1 % beträgt und/oder bei dem die Reflektivität der Antireflex-Beschichtung für die Messstrahlung in dem Detektionswinkelbereich bei weniger als 15 %, bevorzugt bei weniger als 5 %, insbesondere bei weniger als 1 % liegt. Der erste (minimale) Winkel des Detektionswinkelbereichs kann insbesondere bei 20° oder weniger liegen, der zweite Winkel des Detektionswinkelbereichs kann insbesondere bei 60° oder mehr liegen.

Weitere Merkmale und Vorteile der Erfindung ergeben sich aus der nachfolgenden Beschreibung von Ausführungsbeispielen der Erfindung, anhand der Figuren der Zeichnung, die erfindungswesentliche Einzelheiten zeigen, und aus den Ansprüchen.

Zeichnung

Ausführungsbeispiele sind in der schematischen Zeichnung dargestellt und werden in der nachfolgenden Beschreibung erläutert. Es zeigt

Fig. 1a eine schematische Darstellung einer Messvorrichtung zum Prüfen der Oberflächen von Maskenblanks bzw. von Wafern für die Mikrolithographie, insbesondere zur Detektion von Partikeln,

Fig. 1b eine Draufsicht auf eine Maske bzw. auf einen Wafer mit einem Teilbereich, der von der Messvorrichtung mit Messstrahlung bestrahlt wird,

Fig. 2a eine schematische Darstellung von auf die Oberfläche eingestrahlter und an der Oberfläche in einen Detektionswinkelbereich gestreuter Messstrahlung,

Fig. 2b eine schematische Darstellung der zu prüfenden Oberfläche mit einem an der Oberfläche abgelagerten Partikel,

Fig. 3a-c schematische Darstellungen eines zu prüfenden Objekts, bei dem an der zu prüfenden Oberfläche eine Antireflexbeschichtung aufgebracht ist (Fig. 3a,b) bzw. bei dem das Objekt eine Oberflächenstruktur zur Reduzierung der Reflektivität der zu prüfenden Oberfläche aufweist (Fig. 3c),

Fig. 4 eine schematische Darstellung der Häufigkeitsverteilungen der beim Prüfen einer herkömmlichen Oberfläche bzw. der beim Prüfen einer Oberfläche gemäß Fig. 3a-c aufgenommenen Streulichtintensität, sowie

Fig. 5 eine schematische Darstellung der Reflektivitäten der mit zwei unterschiedlichen Antireflex-Beschichtungen versehenen Oberfläche von Fig. 3a innerhalb eines Detektionswinkelbereichs der Messvorrichtung.

In der folgenden Beschreibung der Zeichnungen werden für gleiche bzw. funktionsgleiche Bauteile identische Bezugszeichen verwendet.

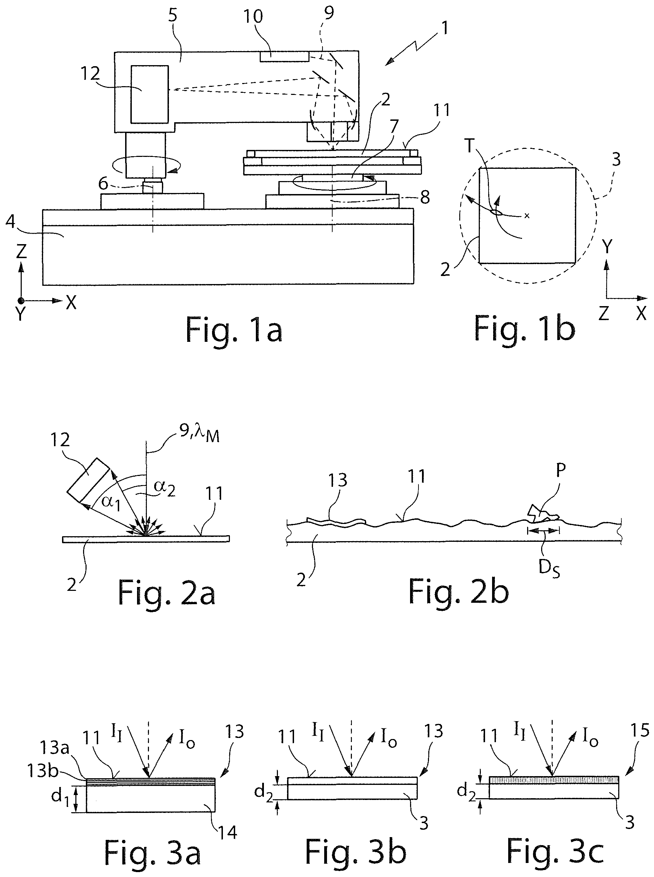

Fig. 1a zeigt eine Messvorrichtung 1 zur Untersuchung einer Maske 2 bzw. eines Wafers 3 mit Hilfe einer Streulichtmessung. Bei der Messvorrichtung 1 kann es sich beispielsweise um eine von der Fa. Rudolph, Inc. unter dem Handelsnamen "Reflex TT MBI" zur Untersuchung von Masken 2 oder unter dem Namen "Reflex TT FSI" zur Untersuchung von Wafern 3 angebotene Messvorrichtung 1 handeln.

Die Messvorrichtung 1 weist einen feststehenden Maschinenkörper 4 auf, an dessen Oberseite ein Messkopf 5 angebracht ist. Der Messkopf 5 ist an dem Maschinenkörper 4 um eine in Z-Richtung eines XYZ-Koordinatensystems verlaufende Drehachse 6 drehbar gelagert. An dem Maschinenkörper 4 ist auch ein um eine weitere, in Z-Richtung verlaufende Drehachse 8 drehbar gelagerter Drehteller 7 angebracht.

Der Messkopf 5 weist eine Messlichtquelle 10 in Form einer Laserdiode zur Erzeugung von Messstrahlung 9 in Form eines Messlichtstrahls bei einer Mess-Wellenlänge $\lambda_M$ von ca. 405 nm auf. Die von der Messlichtquelle 10 ausgesandte Messstrahlung 9 wird an einem Umlenkspiegel in Z-Richtung, d.h. parallel zu den beiden Drehachsen 6, 8 umgelenkt und trifft in einem in Fig. 1b gezeigten, im Wesentlichen runden Teilbereich T auf die Oberseite einer an dem Drehteller 7 gelagerten Maske 2. Der Teilbereich T kann durch die Drehung der Maske 2 um die weitere Drehachse 8 sowie durch die Drehung des Messkopfs 5 um seine Drehachse 6 über die Oberfläche 11 der Maske 2 bewegt werden, so dass der Teilbereich T entlang der gesamten Oberfläche 11 der Maske 2 bewegt bzw. verschoben werden kann. Die Messvorrichtung 1 oder eine geeignet modifizierte Messvorrichtung 1 kann auch zur Untersuchung eines in Fig. 1b gezeigten Wafers 3 eingesetzt werden.

Wie in Fig. 2a zu erkennen ist, wird die senkrecht und somit in Richtung der Flächennormalen auf die plane Oberfläche 11 der Maske 2 eingestrahlte Messstrahlung 9 an der Oberfläche 11 in alle Richtungen einer Halbkugel zurückgestreut. Ein in dem Messkopf 5 angebrachter Detektor 12 detektiert jedoch nur diejenige Messstrahlung 9, die an dem im Wesentlichen punktförmigen Teilbereich T in einem Detektionswinkelbereich gestreut wird, der zwischen einem ersten Streuwinkel $\alpha_1$ und einem zweiten Streuwinkel $\alpha_2$ liegt. Im gezeigten Beispiel liegt der erste Streuwinkel $\alpha_1$ bei 32° und der zweite Streuwinkel $\alpha_2$ liegt bei 68°. Um gestreute Messstrahlung 9 nur in dem Detektionswinkelbereich zwischen dem ersten und zweiten Streuwinkel $\alpha_1$, $\alpha_2$ mit dem Detektor 12 zu detektieren, sind in dem Messkopf 5 ein elliptischer Hohlspiegel sowie ein Lochspiegel integriert. Anders als in Fig. 2a angedeutet ist, ist der Detektionswinkelbereich rotationssymmetrisch zu dem Teilbereich T, d.h. es wird die gesamte in Umfangsrichtung (d.h. über einen Winkel von 360°) an dem Teilbereich T in dem Detektionswinkelbereich rückgestreute Messstrahlung 9 von dem Detektor 12 erfasst.

Da die Messstrahlung 9 senkrecht auf die Oberfläche 11 eingestrahlt wird, müsste die an einer idealen, vollständig planen Oberfläche 11 reflektierte Messstrahlung 9 die Oberfläche 11 ebenfalls in senkrechter Richtung verlassen und daher außerhalb des vom Detektor 12 erfassten Detektionswinkelbereichs liegen. Praktisch weist jede Oberfläche 11 auf mikroskopischer Skala eine Rauigkeit auf, die von der Qualität der verwendeten Polierverfahren, vom Material, aus dem die Oberfläche 11 gebildet ist, etc. abhängig ist. Fig. 2b zeigt einen Ausschnitt einer realen Oberfläche 11, welche eine solche mikroskopische Rauigkeit aufweist. Ebenfalls gezeigt ist ein an der Oberfläche 11 angelagerter Partikel P sowie eine in einem Abschnitt der Oberfläche 11 aufgebrachte Beschichtung 13. Die von dem Detektor 12 aufgefangene, an der Oberfläche 11 gestreute Messstrahlung 9 weist einen ersten Anteil auf, der durch Streulicht hervorgerufen wird, das auf die Rauigkeit der Oberfläche 11 zurückzuführen ist, sowie einen zweiten Anteil, der von Defekten an der Oberfläche 11, beispielsweise auf den in Fig. 2b gezeigten Partikel P, zurückzuführen ist.

Die Gitterperiode G eines Oberflächengitters, ist gemäß folgender Gleichung (Bragg-Gleichung) mit der Mess-Wellenlänge $\lambda_M$ der Messstrahlung 9, dem Einfallswinkel $\alpha_E$ der Messstrahlung 9 und dem Streuwinkel $\alpha_S$ verknüpft:

$$\sin(\alpha_E) - \sin(\alpha_S) = \lambda_M / G.$$

Für senkrechten Einfall der Messstrahlung 9, d.h. für einen Einfallswinkel $\alpha_E$ der Messstrahlung von 0° und eine Messwellenlänge $\lambda_M$ von 408 nm ergibt sich bei einem ersten Streuwinkel $\alpha_1$ von ca. 32° und einem zweiten Streuwinkel $\alpha_2$ von ca. 68° eine maximale Gitterperiode $G_{MAX}$ von ca 800 nm und eine minimale Gitterperiode $G_{MIN}$ von 400 nm, d.h. der oben angegebene Detektionswinkelbereich entspricht einem Ortswellenlängenbereich (bzw. einem Bereich von Gitterperioden G) zwischen ca. 400 nm und ca. 800 nm. Dieser Ortswellenlängenbereich betrifft den ersten Anteil der gestreuten Messstrahlung 9, der durch Streulicht hervorgerufen wird, das auf die Rauigkeit der Oberfläche 11 zurückzuführen ist.

Für Streuzentren bzw. Partikel P, deren Durchmesser $D_S$ bei weniger als ca. der halben Messwellenlänge $\lambda_M$ liegt, gilt näherungsweise, dass die Streulichtintensität I proportional zur sechsten Potenz des Durchmessers ist, d.h. es gilt $I \sim D_S^6$ (Rayleigh-Streuung). Partikel streuen näherungsweise isotrop, so dass die vom Detektor 12 aufgenommene Intensität des zweiten Anteils der gestreuten Messstrahlung 9 nur unwesentlich vom gewählten Detektionswinkelbereich abhängig ist. Durch eine geeignete Wahl des Detektionswinkelbereichs, genauer gesagt des ersten Streuwinkels $\alpha_1$ bzw. des zweiten Streuwinkels $\alpha_2$, der einem Ortswellenlängenbereich entspricht, in dem die Rauigkeit der Oberfläche 11 idealer Weise minimal ist, kann der vom Detektor 12 aufgefangene erste Anteil der gestreuten Messstrahlung 9, der auf die Rauigkeit der Oberfläche 11 zurückzuführen ist, minimiert werden.

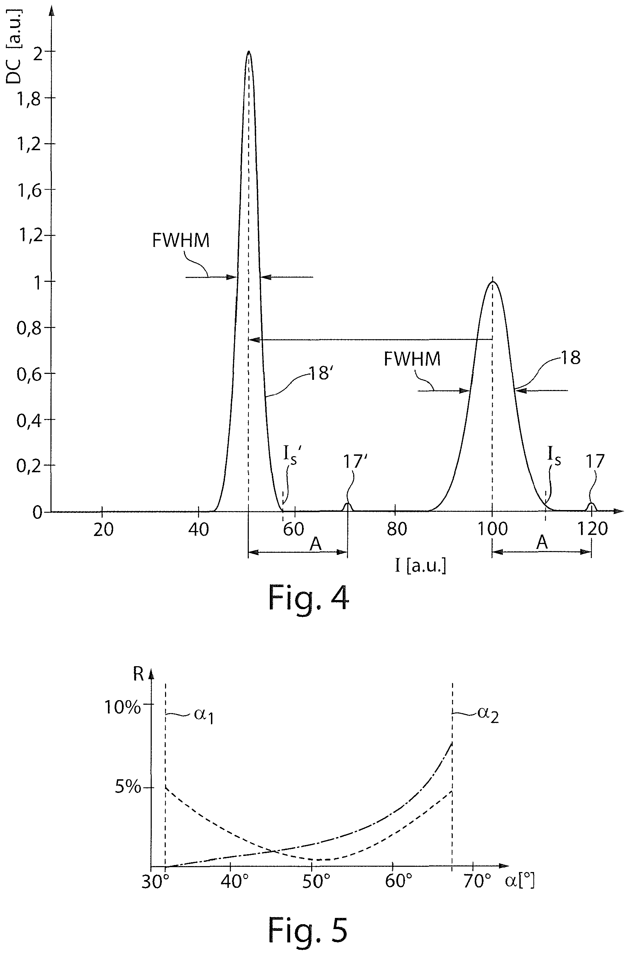

Vergleichsweise große Streuzentren, wie sie durch Partikel P hervorgerufen werden, die typischer Weise in einem Durchmesserbereich zwischen ca. 0,25 $\lambda_M$ und ca. 0,5 $\lambda_M$ liegen, führen insbesondere bei Objekten wie herkömmlichen Si-Wafern und Masken, die im Halbleiterbereich eingesetzt werden, zu einer hohen Streulichtintensität I, während die Rauheit bzw. Unebenheiten der Oberfläche 11, zu einer geringeren Streulichtintensität I führen, wie nachfolgend anhand von Fig. 4 erläutert wird.

Fig. 4 zeigt den so genannten "Defect Count" (D.C.) der Streulichtintensität I, die einen ersten, als Defekt-Signal 17 bezeichneten Anteil sowie einen zweiten, als Haze-Signal 18 bezeichneten Anteil aufweist. Das Haze-Signal 18 stellt eine Häufigkeitsverteilung der an der gesamten Oberfläche 11 gestreuten Messstrahlung 9, d.h. der gesamten bei der Bewegung des Teilbereichs T über die gesamte Oberfläche 11 detektierten Messstrahlung 9 dar, die bei der Messung z.B. in ein Messraster unterteilt werden kann. Beim Defekt-Signal 17 handelt es sich demgegenüber um die Streulichtintensität I, die in einem Teilbereich T gemessen wurde (entsprechend beispielsweise einem Rasterelement des Messrasters). Wie in Fig. 4 zu erkennen ist, weist das Defekt-Signal 17 sein Maximum bei einer größeren Streulichtintensität I auf als das Haze-Signal 18.

Das Defekt-Signal 17 ist auf Partikel P sowie ggf. auf weitere Defekte an der Oberfläche 11 zurückzuführen, während das Haze-Signal 18 im Wesentlichen auf die Rauigkeit der Oberfläche 11 zurückzuführen ist, da größere Defekte wie Partikel P zu einer höheren Streulichtintensität I führen (s.o.). Wird in einem Teilbereich T der Oberfläche 11 eine Streulichtintensität I gemessen, die oberhalb eines Intensitätsschwellwerts $I_S$ liegt, wird davon ausgegangen, dass in dem Teilbereich T ein Partikel P an der Oberfläche 11 vorhanden ist, d.h. bei einer oberhalb des Intensitätsschwellwerts $I_S$ liegenden, von dem Detektor 12 gemessenen Streulichtintensität I wird - bei vorgegebener Bestrahlungsdauer - ein Partikel P detektiert.

Über die in dem Teilbereich T während der Bestrahlungsdauer aufgenommene gestreute Messstrahlung 9 wird aufsummiert bzw. integriert, bevor ein benachbarter Teilbereich T des Messrasters, in das die Oberfläche 11 für die Messung unterteilt wird, auf dieselbe Weise auf Partikel P untersucht wird. Wird in mehreren benachbarten Teilbereichen T eine Streulichtintensität I gemessen, die oberhalb des Schwellwerts $I_S$ liegt, kann mittels geeigneter Algorithmen auf das Vorliegen eines Kratzers oder eines lokalen Flächendefekts an der Oberfläche 11 geschlossen werden Die Überschreitung des Schwellwerts $I_S$ der Streulichtintensität I in einem Teilbereich T der Oberfläche 11 ist daher ein notwendiges, aber ggf. kein hinreichendes Kriterium für das Vorhandensein eines Partikels P in dem Teilbereich T der Oberfläche 11.

Wie in Fig. 4 zu erkennen ist, weist das Haze-Signal 18 eine vergleichsweise große Halbwertsbreite (FWHM) auf, so dass der rechte Rand des im Wesentlichen Gauß-förmigen Haze-Signals 18 ggf. teilweise mit dem Defekt-Signal 17 überlappt. Der rechte Rand des Haze-Signals 18 stellt zwar nur einen vergleichsweise kleinen Anteil der Häufigkeitsverteilung dar, dennoch kann es vorkommen, dass nur aufgrund des Haze-Signals 18 die Streulichtintensität I über dem Intensitätsschwellwert $I_S$ liegt, so dass in dem Teilbereich ein Partikel P detektiert wird, obwohl dort kein Partikel P an der Oberfläche 11 vorhanden ist. Der Intensitätsschwellwert $I_S$ und somit der minimal detektierbare Partikeldurchmesser $D_S$ kann somit nicht beliebig klein gemacht werden, um Fehler bei der Detektion von Partikeln P zu vermeiden.

Um die Nachweisgrenze, d.h. den minimal detektierbaren Partikeldurchmesser $D_S$ zu reduzieren, ist es erforderlich, das Haze-Signal 18 und das Defekt-Signal 17 möglichst gut voneinander zu trennen. Dies kann dadurch erreicht werden, dass die Breite des Haze-Signals 18 verringert wird, so dass sich auch der Intensitätsschwellwert $I_S$ für die Partikelnachweisgrenze verringert. Eine Verringerung der Rauigkeit der Oberfläche 11 könnte dies zwar ebenfalls bewirken, ist aber in der Regel nicht ohne weiteres möglich.

Für die Reduzierung der Nachweisgrenze wird an Stelle eines herkömmlichen Maskenblanks 2 ein plattenförmiges Objekt 14 in die Messvorrichtung 1 von Fig. 1a eingebracht, auf dessen Oberfläche 11 eine Antireflex-Beschichtung 13 aufgebracht ist, wie dies in Fig. 3a gezeigt ist. Wie in Fig. 2b zu erkennen ist, folgt die Oberseite einer Beschichtung 13, die mit einer homogenen Dicke aufgebracht ist, der rauen Oberfläche 11, d.h. die aufgebrachte Beschichtung 13 erhöht die Rauigkeit der Oberfläche 11 nicht. Die Oberfläche 11, die mittels der Messvorrichtung 1 von Fig. 1a geprüft wird, stimmt somit hinsichtlich ihrer Rauheit im Wesentlichen mit der ursprünglichen Oberfläche 11 überein.

Durch die Antireflex-Beschichtung 13 wird die Reflektivität und somit die streuende Wirkung der Oberfläche 11 für die Messstrahlung 9 reduziert, d.h. von der Intensität $I_I$ der bei einem bestimmten Einfallswinkel einfallenden Messstrahlung 9 wird ein geringerer erster Anteil der Intensität $I_O$ reflektiert, als dies bei einer Oberfläche 11 der Fall ist, an der keine Antireflex-Beschichtung 13 aufgebracht ist. Durch die verringerte Reflektivität wird somit der erste Anteil der auf den Detektor 12 auftreffenden Messstrahlung 9 reduziert, der auf die Oberflächenrauigkeit der Oberfläche 11 zurückzuführen ist, wodurch sich die an der Oberfläche 11 gemessene Streulichtverteilung verändert, wie dies in Fig. 4 zu erkennen ist:
Die an der mit der Antireflex-Beschichtung 13 versehenen Oberfläche 11 gemessene Haze-Streulichtverteilung 18' ist in ihrer Streulichtintensität I reduziert, d.h. diese ist in Fig. 4 nach links verschoben. Der Defekt-Peak bzw. das Defekt-Signal 17' ist ebenfalls nach links verschoben, der Abstand A zwischen dem Maximum der Haze-Streulichtverteilung 18' und dem Maximum des Defekt-Signals 17' bleibt jedoch konstant. Dies beruht auf der Annahme, dass sich die gesamte Streulichtintensität I, die von einem Rasterelement der Oberfläche 11 ausgeht, additiv aus dem Streulichtanteil der Oberfläche 11, d.h. dem Haze-Signal 18 bzw. 18', und dem Defekt-Signal 17 bzw. 17' zusammensetzt.

Bei dem in Fig. 4 gezeigten Beispiel wurde davon ausgegangen, dass die Reflektivität der Oberfläche 11 durch die Antrieflex-Beschichtung 13 halbiert wird. Daher reduziert sich die Streulichtintensität, bei welcher das Haze-Signal 18, 18' das Maximum aufweist, von 100 a.u. auf 50 a.u., wie in Fig. 4 gut zu erkennen ist. Entsprechend verändert sich auch die Standardabweichung bzw. der FWHM-Wert des Haze-Signals 18, 18': Bei der Oberfläche 11 ohne Antireflex-Beschichtung liegt der FWHM-Wert bei ca. 10 a.u. (zwischen ca. 95 a.u. und ca. 105 a.u.). Bei der Reduzierung der Reflektivität der Oberfläche 11 auf die Hälfte reduziert sich auch der FWHM-Wert auf die Hälfte, d.h. auf ca. 5 a.u. (105/2 a.u. - 95/2 a.u.). Der Intensitätsschwellwert $I_S$ bzw $I_{S'}$, der typischerweise anhand eines Streuungsmaßes des Haze-Signals 18,18' definiert wird (s.u.), reduziert sich entsprechend. Daher kann der Intensitätsschwellwert $I_S'$ bei dem nach links verschobenen Haze-Signal 18' ebenfalls nach links in Richtung auf das Maximum des verschobenen Haze-Signals 18' verschoben werden, ohne dass hierbei die Fehlerquote bei der Detektion von Partikeln P zunimmt.

Der Intensitätsschwellwert $I_s$ bzw. $I_s'$ kann beispielsweise in Abhängigkeit von der Varianz, dem FWHM-Wert, der Standardabweichung oder einem anderen Streuungsmaß des Haze-Signals 18, 18' festgelegt werden. Beispielsweise kann der Intensitätsschwellwert $I_s$ bzw. $I_{s'}$ als so genannter 3 $\sigma$-Wert definiert werden, d.h. eine Streulichtintensität $I_s$ bzw. $I_s'$, die größer ist als die dreifache Standardabweichung $\sigma$ des Haze-Signals 18, 18' - gemessen ausgehend vom Maximum des Haze-Signals 18, 18' - wird als dem Defekt-Signal 17 zugehörig angesehen und als Vorhandensein eines Partikels P gewertet. Die Streuungsmaße des Haze-Signals 18, 18' können auch ineinander umgerechnet werden, beispielsweise gilt für die Standardabweichung $\sigma$, aus welcher der Intenistätsschwellwert $I_S$ bzw. $I_S'$ bestimmt wird und den in Fig. 4 dargestellten FWHM-Wert folgende Beziehung: FWHM-Wert $\approx 2,3548\ \sigma$.

Bei der auf das plattenförmige Objekt 14 aufgebrachten Antireflex-Beschichtung 13 handelt es sich beim in Fig. 3a gezeigten Beispiel um eine Mehrlagen-Beschichtung, die eine Mehrzahl von Einzelschichten 13a, 13b mit alternierend hohem und niedrigem Brechungsindex für die Mess-Wellenlänge $\lambda_M$ aufweist, deren Schichtdicken so gewählt sind, dass für Messstrahlung 9 bei der Mess-Wellenlänge $\lambda_M$ von 405 nm eine destruktive Interferenz auftritt. Die Reflektivität R des Objekts 14 im Detektionswinkelbereich zwischen dem ersten Streuwinkel $\alpha_1$ und dem zweiten Streuwinkel $\alpha_2$ kann hierbei auf weniger als 5,0 % gesenkt werden, wie in Fig. 5 für zwei Antireflex-Beschichtungen gezeigt ist. Die mit einer strichpunktierten Linie bzw. mit einer gestrichelten Linie dargestellten Reflektivitäten R entsprechen zwei unterschiedlich aufgebauten Antireflex-Beschichtungen 13, die jeweils auf ein Objekt 14 aus Silizium in Form eines Silizium-Wafers aufgebracht wurden. Auf den genauen Schichtaufbau der Antireflex-Beschichtungen 13 wird vorliegend nicht näher eingegangen. Eine der beiden Antireflex-Beschichtungen 13 ist für diesen Detektionswinkelbereich optimiert, so dass die Differenz zwischen einem maximalen Wert $R_{MAX}$ der Reflektivität R und einem minimalen Wert $R_{MIN}$ der Reflektivität R im Detektionswinkelbereich bei weniger als ca. 5 % liegt, d.h. für die Reflektivität R gilt in dem Detektionswinkelbereich: $R_{MAX} - R_{MIN} < 5,0$ %.

Anders als in Fig. 5 für die Reflektivität R der Antireflex-Beschichtung 13 mit der strichpunktierten Linie dargestellt ist, wird die minimale Reflektivität $R_{MIN}$ nicht zwingend beim ersten Streuwinkel $\alpha_1$ erreicht und die maximale Reflektivität $R_{MAX}$ wird nicht zwingend beim zweiten Streuwinkel $\alpha_2$ erreicht. Idealer Weise ist die Reflektivität R der Antireflex-Beschichtung 13 über den gesamten Detektionswinkelbereich (annähernd) konstant, wie dies für die Reflektivität R der Antireflex-Beschichtung 13 der Fall ist, die in Fig. 5 mit der gestrichelten Linie dargestellt ist. Es versteht sich, dass eine entsprechende Antireflex-Beschichtung 13 auch für Messstrahlung 12 im UV-Wellenlängenbereich optimiert sein kann, beispielsweise bei einer Messwellenlänge $\lambda_M$ von z.B. um ca. 248 nm. Für die Optimierung der Antireflex-Beschichtung 13 ist es erforderlich, den Brechungsindex des Objekts 14 zu kennen.

Alternativ zu dem oben beschriebenen Beispiel, bei dem es sich bei dem plattenförmigen Objekt 14 um einen Silizium-Wafer handelt, kann es sich bei dem plattenförmigen Objekt 14 beispielsweise auch um ein optisches Filterglas handeln, insbesondere um ein Langpass-Filterglas, welches unter dem Handelsnahmen RG1000 von der Fa. Schott vertrieben wird und welches für Messstrahlung 9 bei der Mess-Wellenlänge $\lambda_M$ von 405 nm einen Brechungsindex von ungefähr 1,54 aufweist. Das Objekt 14 in Form des Langpass-Filterglases weist bei einer Dicke $d_1$ von 3 mm einen Resttransmissionsgrad von weniger als $10^{-5}$ auf, d.h. von der Rückseite des Objekts 14 wird praktisch keine Messstrahlung 9 reflektiert. Durch die Antireflex-Beschichtung 13 an der Vorderseite des Objekts 14 kann die Reflektivität R der Oberfläche 11 gegenüber einer unbeschichteten Oberfläche 11 um mehr als einen Faktor 18 reduziert werden.

Die Dicke $d_1$ des Objekts 14 und dessen Abmessungen werden so gewählt, das dieses in die Messvorrichtung 1 von Fig. 1a passt, so dass das Objekt 14 in dieser vermessen werden kann. An Stelle eines Wafers oder eines optischen Filterglases können als Objekt 14 auch andere Materialien verwendet werden, beispielsweise Materialien, wie sie für Maskenblanks 2 üblich sind, z.B. Quarzglas, titandotiertes Quarzglas oder eine Glaskeramik (im Fall von Maskenblanks für die EUV-Lithographie). Insbesondere kann ein herkömmlicher Maskenblank 2 für die Vermessung präpariert werden, indem auf diesen eine Antireflex-Beschichtung 13 aufgebracht wird oder indem dieser ggf. mikrostrukturiert wird, wie weiter unten näher beschrieben wird.

Wie weiter oben beschrieben wurde, kann auch ein Wafer 3 für die Vermessung in der Messvorrichtung 1 von Fig. 1a präpariert werden, um das Signal-zu-Rausch-Verhältnis bzw. um die Partikelnachweisgrenze zu senken. Fig. 3b zeigt einen solchen Silizium-Wafer 3, auf den eine Antireflex-Beschichtung 13 aufgebracht ist, die beispielsweise wie in der eingangs zitierten Diplomarbeit "Entspiegelung von Silizium-Photodioden nach dem Vorbild der Nanooptik von Mottenaugen", D. Gäbler, TU Illmenau, 2005, ausgebildet sein kann und die z.B. aus Siliziumnitrid $Si_xN_Y$ bestehen kann.

Durch eine solche Antireflex-Beschichtung 13 kann die Reflektivität R für die Messstrahlung 9 bei der Mess-Wellenlänge $\lambda_M$ von 405 nm gegenüber einer Oberfläche 11 aus unbeschichtetem Silizium etwa um einen Faktor 4 gesenkt werden. Die Reflektivität R von unbeschichtetem Silizium liegt im sichtbaren Wellenlängenbereich typischer Weise bei mehr als ca. 30 %, bei einer Mess-Wellenlänge $\lambda_M$ von 405 nm bei ca. 50 %, und die Reflektivität R der mit der Antireflex-Beschichtung 13 versehenen Oberfläche 11 von Fig. 3b liegt bei weniger als ca. 5 % (vgl. Fig. 5). Der Absorptionskoeffizient von kristallinem Silizium bei der Mess-Wellenlänge $\lambda_M$ liegt bei mehr als $10^5$ 1/cm. Ein handelsüblicher Wafer 3 weist eine Dicke $d_2$ von ca. 650 $\mu$m auf, so dass an der Rückseite des Wafers 3 praktisch keine Messstrahlung 9 mehr ankommt und von dieser zurück reflektiert wird.

Es versteht sich, dass durch eine Optimierung der Antireflex-Beschichtung 13 z.B. durch eine Oberflächenstrukturierung bzw. durch die Wahl einer anderen Mess-Wellenlänge $\lambda_M$ die Reflektivität R des Wafers 3 bzw. der Oberfläche 11 für die Messstrahlung 9 weiter reduziert und somit die Nachweisgrenze für Partikel P bei der Streulichtmessung weiter gesenkt werden kann.

Fig. 3c zeigt einen Wafer 3, bei dem zur Reduzierung der Reflektivität R der Oberfläche 11 eine Oberflächenstruktur 15 aufgebracht ist, bei der es sich im gezeigten Beispiel um so genanntes schwarzes Silizium handelt, d.h. um eine nadelartige Mikrostruktur, die durch hochenergetischen Beschuss mit Ionen oder mit ultrakurzen Laserpulsen erzeugt wurde. Die Oberflächenstruktur 15 in Form des schwarzen Siliziums erhöht die Absorption der Messstrahlung 9 an der Oberfläche 11 und reduziert somit deren Reflektivität R für Messstrahlung 9 bei der Mess-Wellenlänge $\lambda_M$ von 405 nm deutlich, und zwar auf weniger als ca. 2 %, d.h. um einen Faktor von ca. 20. Bei dem Fig. 3c gezeigten Wafer 3 kann daher die Partikelnachweisgrenze gegenüber einem herkömmlichen, nicht oberflächenstrukturierten Wafer 3 deutlich gesenkt werden.

An Stelle eines herkömmlichen Wafers 3 kann die Antireflex-Beschichtung 13 bzw. die Oberflächenstruktur 15 ggf. auch an einem Wafer 3 angebracht werden, der sich von einem herkömmlichen Wafer dadurch unterscheidet, dass auf die Oberfläche 11 eine epitaktisch aufgedampfte Silizium-Schicht aufgebracht wurde, um die Defektanzahl zu verringern. Rauigkeitsmessungen haben gezeigt, dass bei einem Wafer 3 mit einer solchen epitaktischen Silizium-Schicht die Oberflächenrauigkeit gegenüber einem herkömmlichen Silizium-Wafer 3 erhöht ist, wodurch die Partikelnachweisgrenze zunimmt (s.o.). Durch die Reduzierung der Reflexion der Oberfläche 11 eines solchen modifizierten Silizium-Wafers 3 kann die Partikelnachweisgrenze auf einen akzeptablen Wert gesenkt werden. Auch bei anderen Arten von Schichten, die auf einen als Substrat dienenden Wafer 3 oder auf einem Maskenblank 2 aufgebracht sind, kann auf die weiter oben beschriebene Weise die Partikelnachweisgrenze gesenkt werden.

Es versteht sich, dass auch eine Kombination aus einer Oberflächenstruktur 15 und einer auf die strukturierte Oberfläche 11 aufgebrachten Antireflex-Beschichtung 13 eingesetzt werden kann, um die Reflektivität R der Oberfläche 11 zu verringern. Zur Reduzierung der Reflektivität R der Oberfläche 11 kann an Stelle einer nadelförmigen Mikrostruktur beispielsweise auch eine Gitterstruktur oder eine Mottenaugenstruktur verwendet werden.

Grundsätzlich kann die Reflektivität R der Oberfläche 11 auch dadurch reduziert werden, dass ein gradueller oder ggf. kontinuierlicher Übergang des Brechungsindexes von der Umgebung des Objekts 2, 3 14, typischer Weise Luft, zum Material des Objekts 2, 3, 14 erfolgt, d.h. eine Modifikation der Oberfläche 11, die (als effektives Medium) einen solchen Brechungsindexverlauf bzw. einen solchen Übergang erzeugt, führt in der Regel zu einer Reduzierung der Reflektivität der Oberfläche 11. Entsprechende effektive Medien können daher dazu verwendet werden, die Reflektivität R der Oberfläche 11 für die weiter oben beschriebene Detektion von Partikeln P zu reduzieren.

Zusammenfassend kann auf die weiter oben beschriebene Weise, d.h. durch die Verwendung eines Test-Objekts 2, 3, 14 mit einer geeignet modifizierten, in ihrer Reflektivität R reduzierten Oberfläche 11, die Partikelnachweisgrenze gesenkt werden, so dass Partikel P mit kleinerem Partikeldurchmesser $D_S$ detektiert werden können, ohne hierbei die Fehlerquote zu erhöhen.

**Patentansprüche**

1. Verfahren zum Detektieren von abgelagerten Partikeln (P) an einer Oberfläche (11) eines Objekts (2, 3, 14), umfassend:

   Bestrahlen eines Teilbereichs (T) der Oberfläche (11) des Objekts (2, 3, 14) mit Messstrahlung (9),
   Detektieren von an dem bestrahlten Teilbereich (T) gestreuter Messstrahlung (9), sowie
   Detektieren der Partikel (P) an der Oberfläche (11) des Objekts (2, 3, 14) anhand der detektierten Messstrahlung (9),
   **dadurch gekennzeichnet,**
   **dass** die Oberfläche (11) des Objekts (2, 3, 14) bei den Schritten des Bestrahlens und des Detektierens der Messstrahlung (9) mit einer Antireflex-Beschichtung (13) und/oder mit einer Oberflächenstruktur (15) zur Reduzierung der Reflektivität (R) der Oberfläche (11) für die Messstrahlung (9) versehen ist, wobei durch die Antireflex-Beschichtung (13) und/oder die Oberflächenstruktur (15) die Partikelnachweisgrenze gesenkt wird.

2. Verfahren nach Anspruch 1, bei dem die Partikel (P) an der Oberfläche (11) eines Objekts in Form eines Maskenblanks (2) oder eines Wafers (3) für die Mikrolithographie detektiert werden.

3. Verfahren nach Anspruch 1 oder 2, bei dem die Messstrahlung (9) eine vorgegebene Mess-Wellenlänge ($\lambda_M$) aufweist.

4. Verfahren nach einem der vorhergehenden Ansprüche, bei dem die gestreute Messstrahlung (9) in einem Detektionswinkelbereich zwischen einem ersten Streuwinkel ($\alpha_1$) und einem zweiten Streuwinkel ($\alpha_2$) in Bezug auf die einfallende Messstrahlung (9) detektiert wird.

5. Verfahren nach einem der vorhergehenden Ansprüche, bei dem die Antireflex-Beschichtung (13) als Mehrlagen-Beschichtung ausgebildet ist.

6. Verfahren nach Anspruch 4 oder 5, bei dem die Antireflex-Beschichtung (13) in dem Detektionswinkelbereich zwischen dem ersten Streuwinkel ($\alpha_1$) und dem zweiten Streuwinkel ($\alpha_2$) eine winkelabhängige Reflektivität (R) für die Messstrahlung (9) aufweist, bei der eine Differenz zwischen einem maximalen Wert ($R_{MAX}$) der Reflektivität (R) und einem minimalen Wert ($R_{MIN}$) der Reflektivität (R) weniger als 5 %, bevorzugt weniger als 2 %, besonders bevorzugt weniger als 1 % beträgt.

7. Verfahren nach einem der vorhergehenden Ansprüche, bei dem die Reflektivität (R) der Antireflex-Beschichtung (13) für die Messstrahlung (9) bei weniger als 15 %, bevorzugt bei weniger als 5 %, insbesondere bei weniger als 1 % liegt.

8. Verfahren nach einem der vorhergehenden Ansprüche, bei dem die Oberflächenstruktur (15) als nadelartige Mikrostruktur ausgebildet ist.

9. Verfahren nach einem der vorhergehenden Ansprüche, bei dem das Objekt (3) aus Silizium gebildet ist.

10. Verfahren nach Anspruch 9, bei dem die Oberflächenstruktur (15) als schwarzes Silizium ausgebildet ist.

11. Verfahren nach einem der Ansprüche 1 bis 8, bei dem das Objekt (14) aus einem optischen Filterglas zur Filterung der Messstrahlung (9), insbesondere aus einem Langpass-Filterglas, gebildet ist.

12. Verfahren nach einem der vorhergehenden Ansprüche, bei dem das Objekt (2, 3, 14) aus einem Material gebildet ist, das für die Messstrahlung (9) einen Absorptionskoeffizienten von mehr als $1 \times 10^4$ 1/cm aufweist.

13. Verfahren nach einem der vorhergehenden Ansprüche, bei dem das Objekt (2, 3, 14) eine Dicke ($d_1$, $d_2$) von mindestens 500 $\mu$m, bevorzugt von mindestens 1 mm aufweist.

14. Verfahren nach einem der vorhergehenden Ansprüche, bei dem in dem bestrahlten Teilbereich (T) ein Partikel (P) detektiert wird, wenn eine Streulichtintensität (I) der an dem Teilbereich (T) gestreuten Messstrahlung (9) über einem Intensitätsschwellwert ($I_S$) liegt.

15. Verfahren nach einem der vorhergehenden Ansprüche, bei dem zumindest die Schritte des Bestrahlens des Objekts (2, 3, 14) mit der Messstrahlung (9) und des Detektierens der gestreuten Messstrahlung (9) an einer Messvorrichtung (1) zur Vermessung von Wafern (3) oder von Maskenblanks (2) für die Mikrolithographie durchgeführt werden.

**Claims**

1. Method for detecting deposited particles (P) on a surface (11) of an object (2, 3, 14), comprising:

   irradiating a partial region (T) of the surface (11) of the object (2, 3, 14) with measurement radiation (9),
   detecting measurement radiation (9) scattered at the irradiated partial region (T), and

detecting the particles (P) on the surface (11) of the object (2, 3, 14) based on the detected measurement radiation (9),

**characterized**

**in that**, during the steps of irradiating and detecting the measurement radiation (9), the surface (11) of the object (2, 3, 14) is provided with an anti-reflective coating (13) and/or with a surface structure (15) for reducing the reflectivity (R) of the surface (11) for the measurement radiation, wherein the particle detection limit is lowered on account of the anti-reflective coating (13) and/or the surface structure (15).

2. Method according to Claim 1, wherein the particles (P) are detected on the surface (11) of an object in the form of a microlithographic wafer (3) or mask blank (2).

3. Method according to Claim 1 or 2, wherein the measurement radiation (9) has a specified measurement wavelength ($\lambda_M$).

4. Method according to one of the preceding claims, wherein the scattered measurement radiation (9) is detected in a detection angle range between a first scattering angle ($\alpha_1$) and a second scattering angle ($\alpha_2$) with respect to the incident measurement radiation (9).

5. Method according to one of the preceding claims, wherein the anti-reflective coating (13) is formed as a multilayer coating.

6. Method according to Claim 4 or 5, wherein the anti-reflective coating (13) has, in the detection angle range between the first scattering angle ($\alpha_1$) and the second scattering angle ($\alpha_2$), an angle-dependent reflectivity (R) for the measurement radiation (9) at which a difference between a maximum value ($R_{MAX}$) of the reflectivity (R) and a minimum value ($R_{MIN}$) of the reflectivity (R) is less than 5%, preferably less than 2%, with particular preference less than 1%.

7. Method according to one of the preceding claims, wherein the reflectivity (R) of the anti-reflective coating (13) for the measurement radiation (9) is less than 15%, preferably less than 5%, in particular less than 1%.

8. Method according to one of the preceding claims, wherein the surface structure (15) is formed as a needletype microstructure.

9. Method according to one of the preceding claims, in which the object (3) is made from silicon.

10. Method according to Claim 9, wherein the surface structure (15) is formed as black silicon.

11. Method according to one of Claims 1 to 8, wherein the object (14) is formed from an optical filter glass for filtering the measurement radiation (9), in particular from a long-pass filter glass.

12. Method according to one of the preceding claims, wherein the object (2, 3, 14) is made from a material that has, for the measurement radiation (9), an absorption coefficient of more than $1 \times 10^4$ 1/cm.

13. Method according to one of the preceding claims, wherein the object (2, 3, 14) has a thickness ($d_1$, $d_2$) of at least 500 pm, preferably of at least 1 mm.

14. Method according to one of the preceding claims, wherein
a particle (P) is detected in the irradiated partial region (T) when a scattered light intensity (I) of the measurement radiation (9) that is scattered at the partial region (T) lies above an intensity threshold value ($I_S$).

15. Method according to one of the preceding claims, wherein at least the steps of irradiating the object (2, 3, 14) with the measurement radiation (9) and detecting the scattered measurement radiation (9) are performed on a measurement apparatus (1) for measuring microlithographic mask blanks (2) or wafers (3).

**Revendications**

1. Procédé de détection de particules déposées (P) sur une surface (11) d'un objet (2, 3, 14), ledit procédé comprenant les étapes suivantes :

irradier une zone partielle (T) de la surface (11) de l'objet (2, 3, 14) avec un rayonnement de mesure (9),
détecter le rayonnement de mesure (9) diffusé sur la zone partielle irradiée (T), et
détecter les particules (P) sur la surface (11) de l'objet (2, 3, 14) à l'aide du rayonnement de mesure détecté (9),
**caractérisé en ce que**
la surface (11) de l'objet (2, 3, 14) est pourvue d'un revêtement antireflet (13) et/ou d'une structure de surface (15) destiné(e) à réduire, lors des étapes d'irradiation et de détection du rayonnement de mesure (9), la réflectivité (R) de la surface (11) pour le rayonnement de mesure (9), la limite de détection de particules étant abaissée par le revêtement antireflet (13) et/ou la structure de surface (15).

**2.** Procédé selon la revendication 1, dans lequel les particules (P) sont détectées sur la surface (11) d'un objet sous forme d'une ébauche de masque (2) ou d'une plaquette (3) de micro-lithographie.

**3.** Procédé selon la revendication 1 ou 2, dans lequel le rayonnement de mesure (9) a une longueur d'onde de mesure spécifiée ($\lambda_M$).

**4.** Procédé selon l'une des revendications précédentes, dans lequel le rayonnement de mesure diffusé (9) est détecté dans une plage d'angle de détection comprise entre un premier angle de diffusion ($\alpha_1$) et un deuxième angle de diffusion ($\alpha_2$) par rapport au rayonnement de mesure incident (9).

**5.** Procédé selon l'une des revendications précédentes, dans lequel le revêtement antireflet (13) est conçu comme un revêtement multicouche.

**6.** Procédé selon la revendication 4 ou 5, dans lequel le revêtement antireflet (13) présente, dans la plage d'angle de détection comprise entre le premier angle de diffusion ($\alpha_1$) et le deuxième angle de diffusion ($\alpha_2$), une réflectivité (R) dépendante de l'angle pour le rayonnement de mesure (9) pour laquelle la différence entre une valeur maximale ($R_{MAX}$) de la réflectivité (R) et une valeur minimale ($R_{MIN}$) de la réflectivité (R) est inférieure à 5 %, de préférence inférieure à 2 %, de manière particulièrement préférée inférieure à 1 %.

**7.** Procédé selon l'une des revendications précédentes, dans lequel la réflectivité (R) du revêtement antireflet (13) pour le rayonnement de mesure (9) est inférieure à 15 %, de préférence inférieure à 5 %, notamment inférieure à 1 %.

**8.** Procédé selon l'une des revendications précédentes, dans lequel la structure de surface (15) est conçue comme une microstructure en forme d'aiguille.

**9.** Procédé selon l'une des revendications précédentes, dans lequel l'objet (3) est formé à partir de silicium.

**10.** Procédé selon la revendication 9, dans lequel la structure de surface (15) est réalisée en silicium noir.

**11.** Procédé selon l'une des revendications 1 à 8, dans lequel l'objet (14) est formé à partir d'un verre filtre optique destiné à filtrer le rayonnement de mesure (9), notamment à partir d'un verre filtre passe-haut.

**12.** Procédé selon l'une des revendications précédentes, dans lequel l'objet (2, 3, 14) est formé à partir d'un matériau qui présente un coefficient d'absorption supérieur à $1 \times 10^4$ 1/cm pour le rayonnement de mesure (9).

**13.** Procédé selon l'une des revendications précédentes, dans lequel l'objet (2, 3, 14) a une épaisseur ($d_1$, $d_2$) d'au moins 500 pm, de préférence d'au moins 1 mm.

**14.** Procédé selon l'une des revendications précédentes, dans lequel une particule (P) est détectée dans la zone partielle irradiée (T) si une intensité lumineuse diffusée (I) du rayonnement de mesure (9) diffusé sur la zone partielle (T) est supérieure à une valeur d'intensité seuil ($I_S$).

**15.** Procédé selon l'une des revendications précédentes, dans lequel au moins les étapes d'irradiation de l'objet (2, 3, 14) avec le rayonnement de mesure (9) et de détection du rayonnement de mesure diffusé (9) sur un dispositif de mesure (1) sont réalisées afin de mesurer des plaquettes (3) ou des ébauches de masque (2) destinées à la micro-lithographie.

Fig. 1a

Fig. 1b

Fig. 2a

Fig. 2b

Fig. 3a

Fig. 3b

Fig. 3c

Fig. 4

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20160153914 A1

**In der Beschreibung aufgeführte Nicht-Patentliteratur**

- **D. GÄBLER ; TU LLLMENAU.** *Entspiegelung von Silizium-Photodioden nach dem Vorbild der Nanooptik von Mottenaugen,* 2005

- **D. GÄBLER ; TU ILLMENAU.** *Entspiegelung von Silizium-Photodioden nach dem Vorbild der Nanooptik von Mottenaugen,* 2005